# EUROPEAN PATENT APPLICATION

(11) **EP 4 783 778 A2**
(43) Date of publication of application: **29.07.2026**
(21) Application number: 26186159.5
(22) Date of filing: 18.06.2026
(51) Int. Cl.: H10F 19/80, H10F 19/90, H10F 77/00

(54) **PHOTOVOLTAIC MODULE**

(30) Priority: 09.02.2026 CN 202610186624
(71) Applicant: Jinko Solar (Haining) Co., Ltd., Jiaxing, Zhejiang 314415 (CN)
(72) Inventor: HAN, Yu, Haining, 314415 (CN); PENG, Yingying, Haining, 314415 (CN)
(74) Representative: Zacco Sweden AB

(57) **Abstract**

The present application relates to a photovoltaic module. The photovoltaic module includes a cell string and a first busbar. The cell string includes a solar cell having a rear surface. The first busbar is located on the rear surface of the solar cell, and includes a conductive body and an insulating layer. The conductive body is provided with a first outer surface facing the rear surface along the first direction, and the insulating layer is disposed at least on the first outer surface. The conductive body is electrically connected to the cell string.

## Description

### TECHNICAL FIELD

The present application relates to the technical field of photovoltaic technology, and in particular, to a photovoltaic module.

### BACKGROUND

Photovoltaic module generally includes cell strings and busbars. The busbars are configured to collect current generated by the cell strings and transmit the current to an output end of the photovoltaic module, so as to realize electric energy conversion and output. However, photovoltaic modules in the related art are prone to short circuit.

### SUMMARY

Accordingly, it is necessary to provide a photovoltaic module.

A photovoltaic module is provided, which includes a cell string and a first busbar. The cell string includes a solar cell provided with a rear surface. The first busbar is located on the rear surface of the solar cell, and includes a conductive body and an insulating layer. The conductive body has a first outer surface facing the rear surface along a first direction, and the conductive body is electrically connected to the cell string. The insulating layer is disposed at least on the first outer surface. The insulating layer is made of materials including insulating adhesive or ethylene-vinyl acetate copolymer.

In one of the embodiments, the conductive body further includes a second outer surface opposite to the first outer surface along the first direction, and a third outer surface connected between the first outer surface and the second outer surface. The insulating layer is disposed on the first outer surface and the third outer surface.

In one of the embodiments, the insulating layer includes a plurality of insulating sub-layers that are laminated, and adjacent two insulating sub-layers are made of different materials.

In one of the embodiments, a thickness of the insulating layer ranges from 150µm to 250µm.

In one of the embodiments, a plurality of cell strings are provided. Each of the plurality of cell strings includes a plurality of solar cells arranged along a second direction and connected in series sequentially. The photovoltaic module further includes a first welding ribbon electrically connected to the plurality of cell strings. In the plurality of cell strings, a solar cell connected to the first welding ribbon is defined as a first solar cell, and a solar cell adjacent to the first solar cell along the second direction is defined as a second solar cell. The first busbar is disposed on the rear surface of at least one of the first solar cell and the second solar cell. The first welding ribbon is located on a rear surface of the first solar cell, the first welding ribbon extends to a side of the conductive body away from the adjacent solar cell along the first direction, and the first welding ribbon is electrically connected to the conductive body.

In one of the embodiments, the first busbar is disposed on the rear surface of the second solar cell.

In one of the embodiments, the first solar cell and the second solar cell are disposed on an outer side of a same cell string in the second direction, and in the second direction, the first solar cell is located on an outer side of the second solar cell.

In one of the embodiments, the plurality of cell strings are arranged in the second direction. The first solar cell is located in one of adjacent two cell strings in the second direction, and the second solar cell is located in another of the adjacent two cell strings in the second direction.

In one of the embodiments, the plurality of cell strings are arranged in a third direction. The plurality of cell strings arranged in the third direction are electrically connected to the conductive body of a same first busbar.

In one of the embodiments, the plurality of second welding ribbons are spaced apart on the rear surface of the solar cell in the third direction. In each of the plurality of cell strings, adjacent two solar cells are electrically connected via the plurality of second welding ribbons. The first busbar is in contact with the second welding ribbons via the insulating layer.

In one of the embodiments, the cell string includes a plurality of solar cells arranged along a second direction. The photovoltaic module further includes an edge busbar disposed on one side of the cell string in the second direction and electrically connected to the cell string. The conductive body of the first busbar protrudes out of the cell string along the second direction and is electrically connected to the edge busbar.

In one of the embodiments, the insulating layer protrudes out of the cell string along the second direction.

In one of the embodiments, one end of the insulating layer in the second direction is coplanar with one end of the cell string in the second direction.

In one of the embodiments, the conductive body includes a first portion protruding from the insulating layer along the second direction. A dimension of the first portion in the second direction ranges from 0.3 cm to 0.8 cm.

These and other objects, advantages, purposes and features will become apparent upon review of the following specification in conjunction with the drawings.

### BRIEF DESCRIPTION OF THE DRAWINGS

FIG. 1 is a schematic circuit diagram of a photovoltaic module according to an embodiment of the present application.
FIG. 2 is a structural schematic diagram of a first cell and a second cell according to an embodiment of the present application.
FIG. 3 is a side view of a first busbar according to an embodiment of the present application.
FIG. 4 is a side view of a first busbar according to another embodiment of the present application.
FIG. 5 is a structural schematic diagram of a first cell and a second cell according to another embodiment of the present application.
FIG. 6 is a structural schematic diagram of a photovoltaic module according to an embodiment of the present application.
FIG. 7 is a structural schematic diagram of a first busbar according to still another embodiment of the present application.
FIG. 8 is a sectional view taken along line A-A of the first busbar and a first welding ribbon in the embodiment shown in FIG. 7.
FIG. 9 is a structural schematic diagram of a first busbar according to yet another embodiment of the present application.
FIG. 10 is a sectional view taken along line B-B of the first busbar and a second welding ribbon in the embodiment shown in FIG. 9.
FIG. 11 is a circuit schematic diagram of a photovoltaic module according to another embodiment of the present application.
FIG. 12 is a structural schematic diagram of a first busbar according to a further embodiment of the present application.
FIG. 13 is a top view of a first busbar and a plurality of cell strings according to an embodiment of the present application.
FIG. 14 is a top view of a first busbar and a plurality of cell strings according to another embodiment of the present application.
FIG. 15 is a side view of a photovoltaic module according to an embodiment of the present application.
FIG. 16 is a structural schematic diagram of a feeding mechanism according to an embodiment of the present application.
FIG. 17 is a structural schematic diagram of a curing mechanism according to an embodiment of the present application.

### DETAILED DESCRIPTION OF THE EMBODIMENTS

To make the foregoing objectives, features and advantages of the present application more obvious and understandable, the specific embodiments of the present application will be described in detail below with reference to the accompanying drawings. Numerous specific details are set forth in the following description to facilitate a thorough understanding of the present application. However, the present application may be implemented in many other manners different from those described herein. Those skilled in the art may make similar improvements without departing from the connotation of the present application, so the present application is not limited to the specific embodiments disclosed below.

In the description of the present application, it should be understood that terms such as center, longitudinal, transverse, length, width, thickness, upper, lower, front, rear, left, right, vertical, horizontal, top, bottom, inner, outer, clockwise, counterclockwise, axial, radial and circumferential indicate orientations or positional relationships based on those shown in the accompanying drawings, which are merely for convenience of description and simplification, and do not indicate or imply that the referred devices or elements must have specific orientations, be constructed and operated in specific orientations, and thus shall not be construed as limitations to the present application.

In addition, terms such as first and second are used merely for descriptive purposes, and shall not be construed as indicating or implying relative importance or implicitly specifying the quantity of indicated technical features. Accordingly, features defined as "first" and "second" may explicitly or implicitly include at least one such feature. In the description of the present application, the term "a plurality of" means at least two, such as two, three and the like, unless otherwise clearly specified and limited.

In the present application, unless otherwise clearly specified and limited, terms such as mount, couple, connect and fix shall be construed in a broad sense. For example, it may be fixed connection, detachable connection or integral connection; it may be mechanical connection or electrical connection; it may be direct connection or indirect connection via intermediate medium, or internal communication or interaction relationship between two elements, unless otherwise clearly defined. Those of ordinary skill in the art may understand the specific meanings of the above terms in the present application according to actual circumstances.

In the present application, unless otherwise clearly specified and limited, descriptions that a first feature is "on" or "under" a second feature mean that the first feature may be in direct contact with the second feature, or in indirect contact therewith through an intermediate medium. Moreover, the expressions that the first feature is "above", "over" and "on" the second feature may mean that the first feature is directly above or obliquely above the second feature, or merely indicates that the horizontal height of the first feature is higher than that of the second feature. The expressions that the first feature is "below", "beneath" and "under" the second feature may mean that the first feature is directly below or obliquely below the second feature, or merely indicates that the horizontal height of the first feature is lower than that of the second feature.

It should be noted that if an element is referred to as being "fixed to" or "arranged on" another element, it may be directly disposed on the other element or there may be an intermediate element therebetween. If an element is deemed to be "connected" to another element, it may be directly connected to the other element or there may be an intermediate element therebetween. Where applicable, the terms vertical, horizontal, upper, lower, left, right and similar expressions used in the present application are only for illustrative purposes and do not represent the only embodiments.

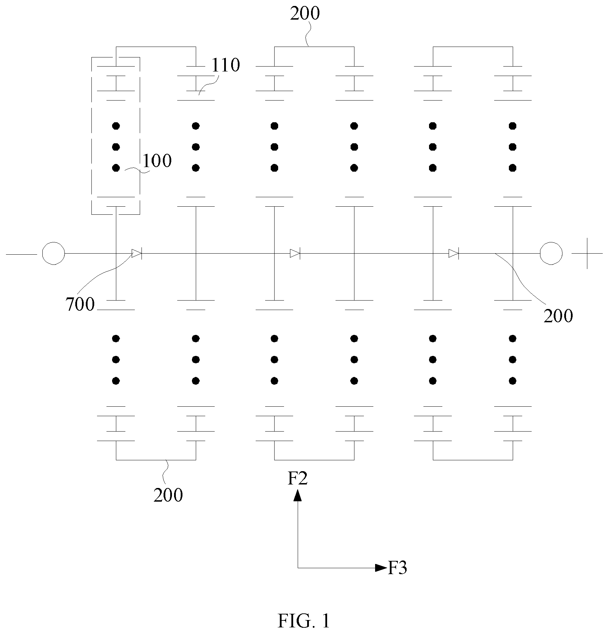

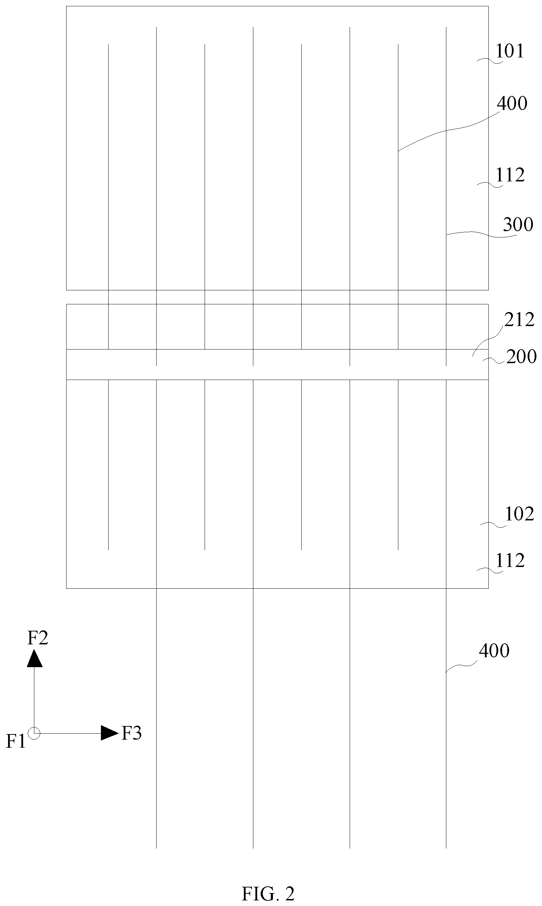

FIG. 1 is a schematic circuit diagram of a photovoltaic module according to an embodiment of the present application, and FIG. 2 is a structural schematic diagram of a first solar cell and a second solar cell according to an embodiment of the present application.

Referring to FIG. 1 and FIG. 2, an embodiment of the present application provides a photovoltaic module, which includes a cell string 100 and a first busbar 200.

The cell string 100 includes a solar cell 110. The solar cell 110 has a front surface 111 and a rear surface 112 opposite to each other along a first direction F1.

The solar cell 110 may be a Tunnel Oxide Passivated Contact (TOPCon) cell, a Back Contact (BC) cell or the like.

The first direction F1 may be perpendicular to a thickness direction of the solar cell 110.

The front surface 111 refers to a surface of the solar cell 110 where light enters, which may also be referred to as a light receiving surface. The rear surface 112 is opposite to the front surface 111 of the solar cell 110, and may also be referred to as a backlight surface.

The first busbar 200 is located on the rear surface 112 of the solar cell 110, that is, the first busbar 200 is located on a side of the solar cell 110 away from the front surface 111. The first busbar 200 includes a conductive body 210 and an insulating layer 220.

The conductive body 210 includes a first outer surface 211 facing the rear surface 112 along the first direction F1, and a second outer surface 212 opposite to the first outer surface 211 along the first direction F1. The insulating layer 220 is disposed at least on the first outer surface 211, and the conductive body 210 is electrically connected to the cell string 100.

The conductive body 210 refers to a part of the first busbar 200 that is conductive and configured to be electrically connected to the cell string 100.

The first outer surface 211 and the second outer surface 212 are two opposite side surfaces of the conductive body 210 along the first direction F1. Generally, the first outer surface 211 is configured for the insulating layer 220 to be disposed thereon, and the second outer surface 212 is configured to be electrically connected to the cell string 100. It can be understood that along the first direction F1, the first outer surface 211 is closer to the solar cell 110 than the second outer surface 212. The first direction F1 is also parallel to a thickness direction of the first busbar 200.

The insulating layer 220 refers to a layer disposed at least on the first outer surface 211 and configured to electrically isolate the conductive body 210 from opposite-polarity grid lines of the solar cell 110.

It can be understood that along the first direction F1, the insulating layer 220 is arranged closer to the solar cell 110 than the conductive body 210. Such arrangement enables the conductive body 210 of the first busbar 200 to be electrically connected to the cell string 100. While the conductive body 210 collects current of the cell string 100, the insulating layer 220 can electrically separate the conductive body 210 from opposite-polarity grid lines of the solar cell 110. In addition, since the insulating layer 220 is disposed at least on the first outer surface 211, the insulating layer 220 and the conductive body 210 form an integrated structure. As such, during the lamination process of the photovoltaic module, compared with a separately arranged isolation layer which is prone to thermal shrinkage and displacement during the lamination process, the integrally formed insulating layer 220 and conductive body 210 in the present embodiment can lower the possibility of displacement of the insulating layer 220 relative to the conductive body 210, thus reducing the possibility of contact between the first busbar 200 and opposite-polarity grid lines, decreasing the possibility of short circuit of the photovoltaic module, and further improving the reliability of the photovoltaic module. Moreover, since the first busbar 200 is disposed on the rear surface 112 of the solar cell 110, when light enters the solar cell 110 from the front surface 111, the first busbar 200 will not block incident light, such that the light receiving area and power generation efficiency of the photovoltaic module can be enhanced.

The insulating layer 220 can be made of insulating adhesive or ethylene-vinyl acetate copolymer.

The insulating layer 220 may be formed by spraying. Alternatively, it can be formed by heat treatment. For example, an initial insulating layer is arranged at least on the first outer surface 211 of the conductive body 210. The initial insulating layer is heated first and then cured, such that the initial insulating layer is bonded at least to the first outer surface 211 of the conductive body 210, thereby forming the insulating layer 220 disposed at least on the first outer surface 211 of the conductive body 210.

Since the insulating layer 220 is made of insulating adhesive or ethylene-vinyl acetate copolymer, it can electrically isolate the conductive body 210 from the opposite-polarity grid lines of the solar cell 110, and the insulating layer 220 can be more firmly attached to the conductive body 210, as both insulating adhesive and ethylene-vinyl acetate copolymer possess strong adhesive force.

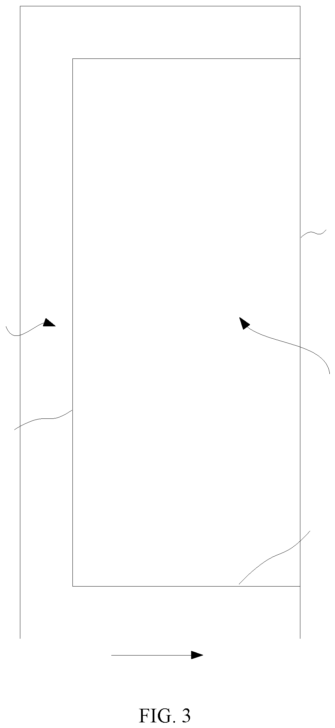

Referring to FIG. 3, the conductive body 210 is further provided with a third outer surface 213 connected between the first outer surface 211 and the second outer surface 212, and the insulating layer 220 is disposed on the first outer surface 211 and the third outer surface 213.

The third outer surface 213 refers to a surface of the conductive body 210 located between the first outer surface 211 and the second outer surface 212 along the first direction F1.

Since the insulating layer 220 is disposed on the first outer surface 211 and the third outer surface 213, and the first outer surface 211 is closer to the solar cell 110 than the second outer surface 212 along the first direction F1, the insulating layer 220 arranged on the third outer surface 213 can effectively reduce the contact possibility between the conductive body 210 and the opposite-polarity grid lines of the solar cell 110. This lowers the possibility of short circuit of the photovoltaic module and improves the operational reliability of the photovoltaic module.

In some embodiments, the insulating layer 220 includes a plurality of insulating sub-layers that are laminated, and adjacent two insulating sub-layers are made of different materials.

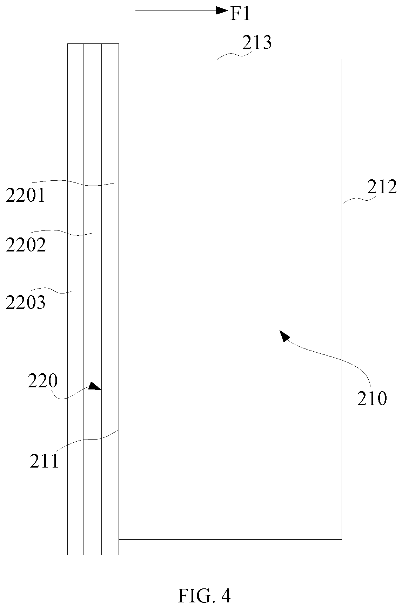

As shown exemplarily in FIG. 4, three insulating sub-layers are arranged, namely a first insulating sub-layer 2201, a second insulating sub-layer 2202, and a third insulating sub-layer 2203, respectively. The first insulating sub-layer 2201 is made of ethylene-vinyl acetate copolymer (EVA), the second insulating sub-layer 2202 is made of polyethylene terephthalate (PET), and the third insulating sub-layer 2203 is made of ethylene-vinyl acetate copolymer (EVA).

Different materials are adopted for adjacent insulating sub-layers. The insulating sub-layer closer to the conductive body 210 along the first direction F1 is selected from materials with high adhesion, such as ethylene-vinyl acetate copolymer (EVA), while the insulating sub-layer farther away from the conductive body 210 along the first direction F1 is selected from materials with superior electrical isolation performance. For instance, the second closest insulating sub-layer to the conductive body 210 along the first direction F1 adopts polyethylene terephthalate (PET). This structure realizes favorable electrical isolation between the conductive body 210 and opposite-polarity grid lines of the solar cell 110, and enables the insulating layer 220 to be firmly fixed on the conductive body 210.

In some embodiments, the thickness of the insulating layer 220 ranges from 150 µm to 250 µm.

For example, the thickness may range from 160 µm to 250 µm, or 150 µm to 240 µm.

Exemplarily, the thickness of the insulating layer 220 may be 150 µm, 160 µm, 170 µm, 180 µm, 190 µm, 200 µm, 210 µm, 220 µm, 230 µm, 240 µm or 250 µm.

If the insulating layer 220 is excessively thin, it is prone to transform from a glassy state to a molten state during the lamination process, which causes the insulating layer 220 on the conductive body 210 to be squeezed out from between the conductive body 210 and the solar cell 110 and further results in overlapping short circuit. If the insulating layer 220 is excessively thick, it may cause hidden cracks of the solar cell 110 in the lamination process. Therefore, the thickness of the insulating layer 220 shall be controlled within a proper range, preferably from 150 µm to 250 µm. Such arrangement can not only reduce the risk of the insulating layer being squeezed out, but also lower the occurrence probability of hidden cracks of solar cells, so as to enhance the overall reliability of photovoltaic modules.

In some embodiments, the solar cell 110 is a back contact cell (BC).

Specifically, a plurality of cell strings 100 are provided. The cell string 100 includes a plurality of solar cells 110 arranged along the second direction F2 and connected in series sequentially. The photovoltaic module further includes a first welding ribbon 300 electrically connected to the cell string 100. In the cell string 100, the solar cell 110 connected to the first welding ribbon 300 is defined as a first solar cell 101, and the solar cell 110 adjacent to the first solar cell 101 along the second direction F2 is defined as a second solar cell 102. The first busbar 200 is disposed on the rear surface 112 of at least one of the first solar cell 101 and the second solar cell 102. The first welding ribbon 300 is arranged on the rear surface 112 of the first solar cell 101, extends to a side of the conductive body 210 away from the adjacent solar cell 110 along the first direction F1, and is electrically connected to the conductive body 210.

It can be understood that the first busbar 200 is disposed on the side of the rear surface 112 of at least one of the first solar cell 101 and the second solar cell 102 away from the front surface 111. The first welding ribbon 300 is located on the side of the rear surface 112 of the first solar cell 101 away from the front surface 111.

On the one hand, arranging the first busbar 200 on the side of the rear surface 112 of at least one of the first solar cell 101 and the second solar cell 102 away from the front surface 111 can increase the light receiving area of the photovoltaic module, thereby boosting its power generation efficiency. On the other hand, the first welding ribbon 300 extends to the side of the conductive body 210 away from the adjacent solar cell 110 along the first direction F1, thereby enabling direct welding between the first welding ribbon 300 and the conductive body 210. Thus, compared with the conventional hole-punching process of the insulating layer 220 (achieving the electrical connection between the conductive body 210 and the first welding ribbon 300 by hole-punching the insulating layer 220), the present embodiment omits such hole punching process, which improves welding efficiency and reduces production costs.

In some embodiments, the first busbar 200 is disposed on the rear surface 112 of the second solar cell 102.

It is understood that the first busbar 200 is disposed on the side of the rear surface 112 of the second solar cell 102 away from the front surface 111.

Since the first welding ribbon 300 is located on the side of the rear surface 112 of the first solar cell 101 away from the front surface 111, the first welding ribbon 300 and the first busbar 200 are located on the rear surfaces away from the front surfaces of different solar cells 110. After being welded to a plurality of bonding pads of the first solar cell 101, the first welding ribbon 300 can extend to the side of the conductive body 210 away from the adjacent solar cell 110 along the first direction F1 without being folded over, thus improving the reliability of the first welding ribbon 300.

In some embodiments, the first solar cell 101 and the second solar cell 102 are located on the outer side of the same cell string 100 along the second direction F2; and along the second direction F2, the first solar cell 101 is located on the outer side of the second solar cell 102 (as shown in FIG. 2).

It can be understood that in this embodiment, the first solar cell 101 is the outermost solar cell 110 in the cell string 100 along the second direction F2, and the second solar cell 102 is the second outermost solar cell 110 in the cell string 100 along the second direction F2. In this embodiment, the first busbar 200 is disposed adjacent to a side edge of the photovoltaic module along the second direction F2. As the first welding ribbon 300 is located on the side of the rear surface 112 of the first solar cell 101 away from the front surface 111, the first welding ribbon 300 extends inward to the side of the rear surface 112 of the inner second solar cell 102 away from the front surface 111, and further extends to the side of the conductive body 210 away from the second solar cell 102 along the first direction F1. That is to say, the first welding ribbon 300 is led inward and welded to the side of the conductive body 210 away from the second solar cell 102 along the first direction F1. Thus, compared to the conventional hole-punching process of the insulating layer 220 (achieving the electrical connection between the conductive body 210 and the first welding ribbon 300 by drilling holes in the insulating layer 220), the present embodiment eliminates the hole-punching process, which improves welding efficiency and reduces production costs. Meanwhile, the light receiving area of the photovoltaic module is increased to raise its power generation capacity. In addition, the first welding ribbon 300 can extend to a side of the conductive body 210 away from the adjacent solar cell 110 along the first direction F1 without folding, such that the reliability of the first welding ribbon 300 is effectively enhanced.

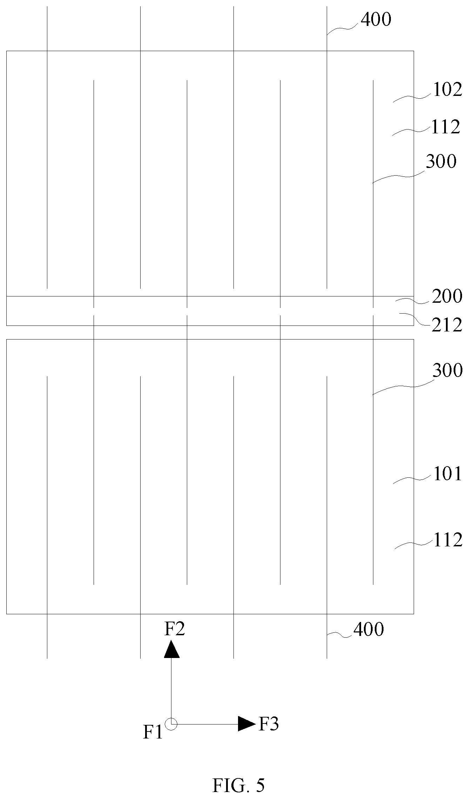

In some embodiments, the photovoltaic module includes a plurality of cell strings 100 arranged along the second direction F2. The first solar cell 101 is located in one of adjacent two cell strings 100 along the second direction F2, and the second solar cell 102 is located in another of the adjacent two cell strings 100 along the second direction F2 (as shown in FIG. 5).

In this embodiment, the first busbar 200 is substantially arranged at the middle position of the photovoltaic module, and can simultaneously collect currents from adjacent two cell strings 100 along the second direction F2, such that the adjacent two cell strings 100 along the second direction F2 are connected in parallel to the first busbar 200. Since the first busbar 200 is located on the side of the rear surface 112 of the second solar cell 102 away from the front surface 111, the light receiving area of the photovoltaic module can be increased to improve the power generation output of the photovoltaic module. Compared with the conventional hole punching process for the insulating layer 220, the present embodiment omits such hole punching process, which improves welding efficiency and reduces manufacturing costs. Meanwhile, the first welding ribbon 300 can extend to the side of the conductive body 210 away from the adjacent solar cell 110 along the first direction F1 without folding, so as to enhance the reliability of the first welding ribbon 300.

In some embodiments, the photovoltaic module includes a plurality of cell assemblies, each of which includes a first solar cell 101 and a second solar cell 102. In one cell assembly, the first solar cell 101 and the second solar cell 102 are disposed on the outer side of the same cell string 100 along the second direction F2, and the first solar cell 101 is located on the outer side of the second solar cell 102 along the second direction F2. In another cell assembly, the first solar cell 101 is located in one of adjacent two cell strings 100 along the second direction F2, and the second solar cell 102 is arranged in another of the adjacent two cell strings 100 along the second direction F2 (refer to FIG. 2, FIG. 5 and FIG. 6).

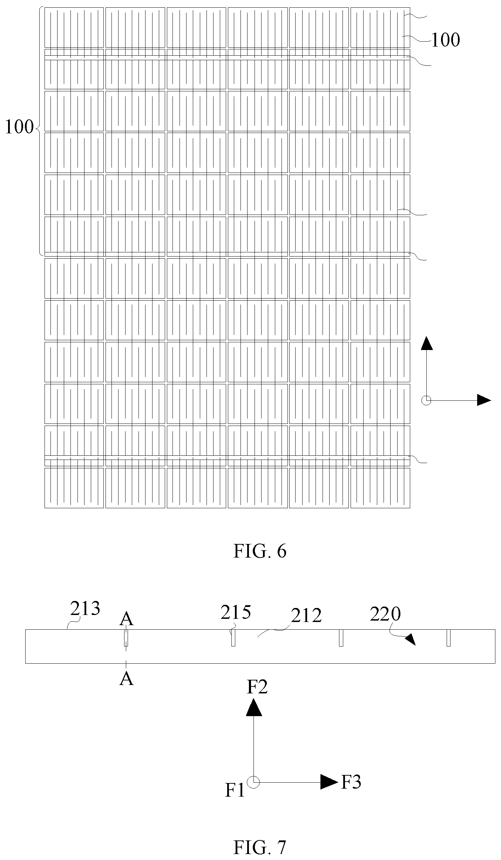

It can be understood that the photovoltaic module includes a plurality of first busbars 200. A part of the first busbars 200 are substantially located at the edge positions of the photovoltaic module, and another part of the first busbars 200 are located substantially at the middle positions thereof. Taking the embodiment shown in FIG. 6 as an example, the first busbars 200 arranged adjacent to one side edge of the photovoltaic module along the second direction F2 can connect adjacent two cell strings 100 in series along the third direction F3. The two serially connected cell strings 100 are further reversely connected in parallel to a diode 700 via the first busbar 200 disposed adjacent to the middle of the photovoltaic module, so as to alleviate the hot spot effect, protect the photovoltaic module and guarantee stable power generation performance of the photovoltaic module.

In some embodiments as shown in FIG. 6, the photovoltaic module includes a plurality of cell strings 100 arranged along the third direction F3, and the plurality of cell strings 100 are electrically connected to the conductive body 210 of the same first busbar 200.

The plurality of cell strings 100 arranged along the third direction F3 may be connected in series through the first busbars 200 arranged adjacent to the side edge along the second direction F2 and through the first busbars 200 arranged adjacent to the middle position of the photovoltaic module, so as to increase the overall power generation capacity of the photovoltaic module.

Specifically in the embodiments illustrated in FIG. 1 and FIG. 6, the photovoltaic module includes twelve cell strings 100. Six of the cell strings 100 arranged along the third direction F3 are electrically connected to the first busbar 200 adjacent to one side edge of the photovoltaic module along the second direction F2, such that the six cell strings are connected in series to form a first cell group. The other six cell strings 100 arranged along the third direction F3 are electrically connected to the first busbar 200 adjacent to the other side edge of the photovoltaic module along the second direction F2, so as to form a second cell group through series connection of the six cell strings. The first cell group and the second cell group are connected in parallel to the first busbar 200 arranged adjacent to the middle position of the photovoltaic module.

It can be understood that in this embodiment, the same first busbar 200 is located on a side away from the front surface 111 of the rear surface 112 of the second solar cells 102 of the plurality of cell strings 100 arranged along the third direction F3.

As such, while realizing electrical connection in the plurality of cell strings 100 arranged along the third direction F3, the arrangement can increase the light receiving area of the photovoltaic module and further improve the power generation output of the photovoltaic module.

It should be noted that the number of solar cells 110 in each cell string 100 shown in FIG. 6 is merely illustrative and not limited thereto.

In addition, the number of the first welding ribbons 300 connected to the first busbars 200 and the number of the second welding ribbons 400 configured to connect adjacent two solar cells 110 in FIG. 6 are only set for clear schematic illustration, and the number of the first welding ribbons 300 and the number of the second welding ribbons 400 are not limited herein.

In one embodiment, the photovoltaic module further includes a plurality of second welding ribbons 400, which are spaced apart on the rear surface 112 of the solar cells 110 along the third direction F3. In each cell string 100, adjacent two solar cells 110 are electrically connected via the second welding ribbons 400. The first busbar 200 is in contact with the second welding ribbons 400 through the insulating layer 220.

The second welding ribbons 400 is configured to electrically connect adjacent solar cells 110 within the same cell string 100. The first busbar 200 may be configured to collect current of the cell strings 100, and is electrically isolated from the opposite-polarity second welding ribbons 400 by means of the insulating layer 220, so as to reduce the occurrence of short circuits.

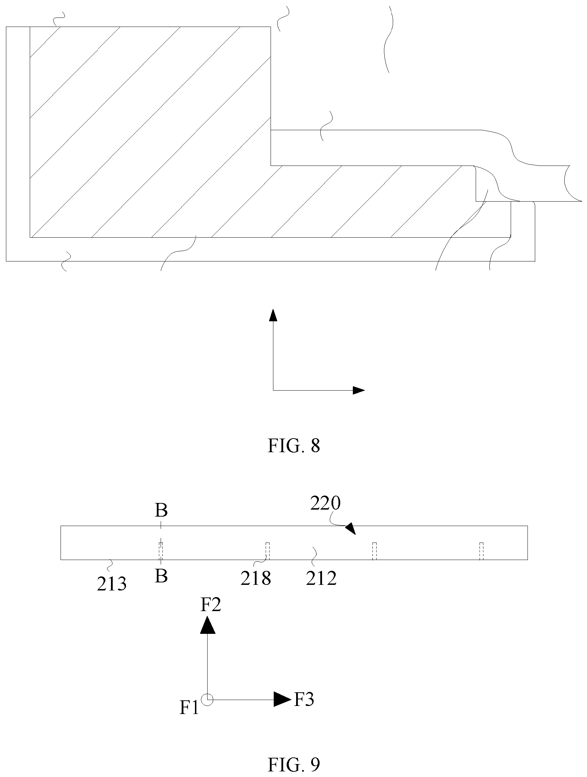

In some embodiments, with reference to FIG. 7 and FIG. 8, the third outer surface 213 is provided with a welding groove 215. A side wall of the welding groove 215 adjacent to the second outer surface 212 is provided with a welding opening 216 in communication with the welding groove 215. An end of the first welding ribbon 300 connected to the conductive body 210 is located inside the welding groove 215.

The end of the first welding ribbon 300 to be welded to the conductive body 210 can be disposed in the welding groove 215 to realize preliminary positioning of the end of the first welding ribbon 300 to be welded to the conductive body 210. Therefore, it facilitates the welding mechanism to inject solder into the welding groove 215 and reduces solder overflow, and it ensures reliable welding between the first welding ribbon 300 and the conductive body 210, and lowers the possibility of short circuit caused by solder overflow.

Optionally, the third outer surface 213 of the conductive body 210 is further provided with an inclined groove 217, and the inclined groove 217 is in communication with the welding groove 215 to form a stepped groove. Along the first direction F1, the inclined groove 217 is disposed closer to the first outer surface 211 than the welding groove 215.

During welding, the second outer surface 212 of the conductive body 210 is placed upward. In this state, the inclined groove 217 is lower in position than the welding groove 215, which allows the first welding ribbon 300 to smoothly ascend into the welding groove 215 via the inclined groove 217. The bending radian of the first welding ribbon 300 is reduced, so that the service reliability thereof is improved.

It should be noted that the insulating layer 220 is arranged on the first outer surface 211 and the third outer surface 213 of the conductive body 210, which can reduce the contact possibility between the first welding ribbon 300 and opposite-polarity grid lines and further decrease the possibility of short circuit.

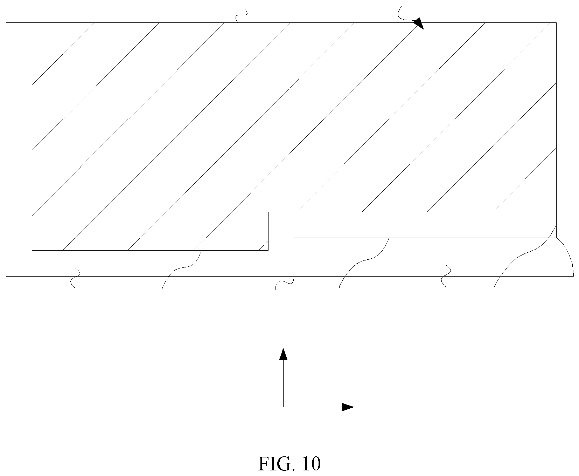

In some embodiments, with reference to FIG. 9 and FIG. 10, an accommodating groove 218 is formed on the third outer surface 213 of the conductive body 210. The accommodating groove 218 and the welding groove 215 are arranged on two opposite third outer surfaces 213, respectively. The insulating layer 220 is also disposed on the groove walls of the accommodating groove 218.

The second welding ribbon 400 can be received inside the accommodating groove 218 and abut against the bottom wall of the accommodating groove 218. This structure reduces the fracture risk of the second welding ribbon 400, lowers the probability of hidden cracks of the solar cell 110 during lamination, achieves electrical isolation between the first busbar 200 and the second welding ribbon 400, and minimizes contact between the second welding ribbon 400 and the first welding ribbon 300 caused by displacement, thereby reducing the possibility of short circuit.

Optionally, the orthographic projections of the accommodating groove 218 and the welding groove 215 on a plane parallel to the first outer surface 211 do not overlap with each other, which can improve the reliability of the first busbar 200.

Optionally, a first opening 219 in communication with a groove opening of the accommodating groove 218 is formed on the first outer surface 211 of the conductive body 210, and the first opening 219 extends from the groove opening of the accommodating groove 218 to the bottom wall of the accommodating groove 218.

As such, the accommodating groove 218 can better accommodate the second welding ribbon 400.

Optionally, the second welding ribbon 400 is positioned inside the accommodating groove 218 via curing adhesive (not shown).

This arrangement further prevents contact between the second welding ribbon 400 and the first welding ribbon 300 due to position shift, and effectively reduces the possibility of short circuit.

Optionally, the groove walls of the accommodating groove 218 are fixed to the solar cell 110 where the first busbar 200 is located by curing adhesive (not shown).

As such, the possibility of short circuit resulting from displacement of the first busbar 200 can be reduced.

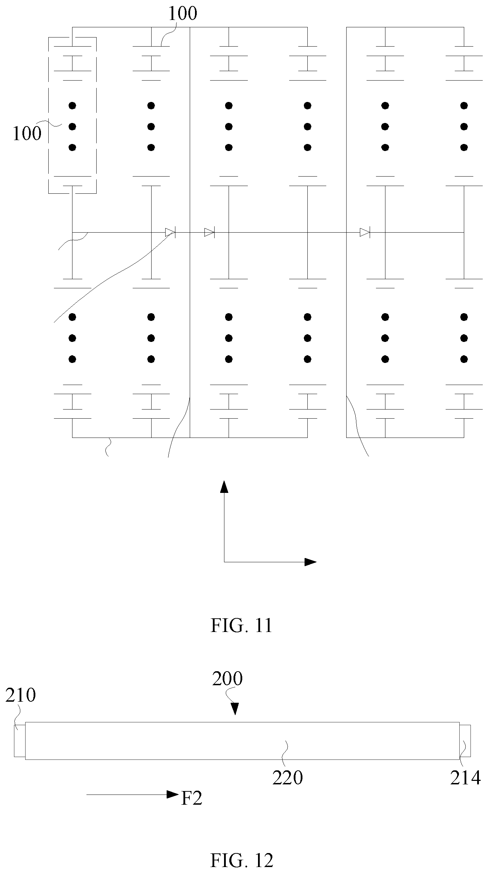

With reference to FIG. 11, in other embodiments, the solar cell 110 is a Tunnel Oxide Passivated Contact cell (TOPCon).

Specifically, each cell string 100 includes a plurality of solar cells 110 arranged along the second direction F2. The photovoltaic module further includes a plurality of edge busbars 500, which are disposed on one side of each cell string 100 along the second direction F2 and electrically connected thereto. The conductive body 210 of the first busbar 200 protrudes outward from the cell string 100 along the second direction F2 and is electrically connected to the edge busbar 500.

On the one hand, since the conductive body 210 of the first busbar 200 protrudes beyond the cell string 100 along the second direction F2 and is electrically connected to the edge busbar 500, the edge busbar 500 and the first busbar 200 can jointly collect current from the cell string 100. In addition, the cell string 100 can be reversely connected in parallel with the diode 700 through the edge busbar 500 and the first busbar 200, so as to mitigate the hot spot effect, protect the photovoltaic module and ensure stable power generation thereof. On the other hand, the insulating layer 220 of the first busbar 200 is in contact with the plurality of solar cells 110 of the same cell string 100. The insulating layer 220 can isolate the conductive body 210 of the first busbar 200 from the grid lines of the solar cells 110 and the welding ribbons electrically connected to the solar cells 110, so as to avoid mutual contact and reduce the occurrence possibility of short circuit.

In some embodiments, as shown in FIG. 12, the conductive body 210 includes a first portion 214 protruding from the insulating layer 220 along the second direction F2. The dimension of the first portion 214 in the second direction F2 ranges from 0.3 cm to 0.8 cm.

By way of example, the dimension of the first portion 214 in the second direction F2 may be 0.3 cm, 0.4 cm, 0.5 cm, 0.6 cm, 0.7 cm or 0.8 cm.

Setting the dimension of the first portion 214 along the second direction F2 within a proper range, i.e. 0.3 cm to 0.8 cm, can ensure that the first portion 214 has a sufficient protruding length from the insulating layer 220 to facilitate welding with the edge busbar 500, and meanwhile lowers the manufacturing cost of the first busbar 200.

Specifically, the conductive body 210 includes two first portions 214. One of the first portions 214 is electrically connected to the edge busbar 500 at one end of the photovoltaic module, and the other one of the first portions 214 is electrically connected to the edge busbar 500 at the other end of the photovoltaic module.

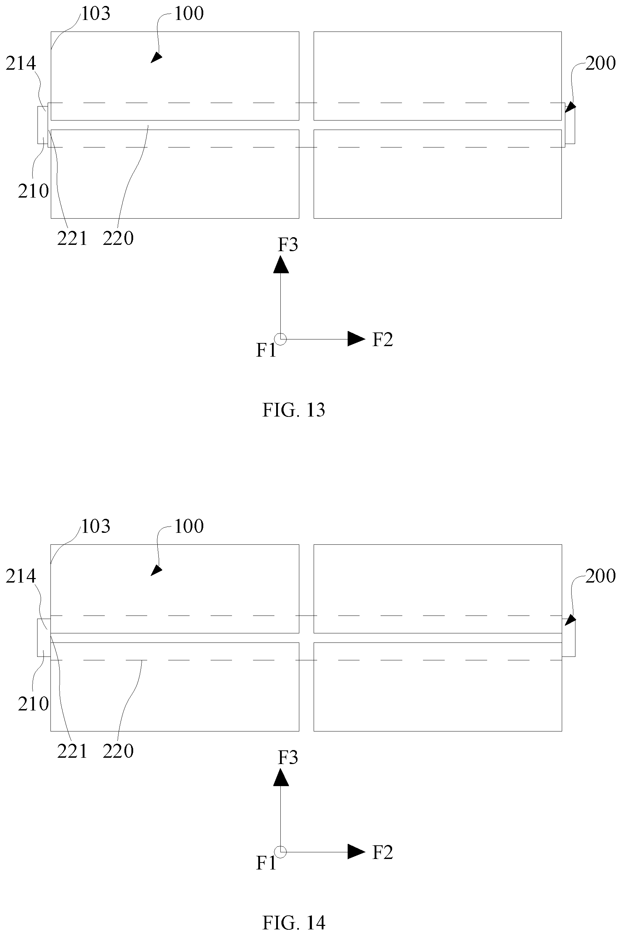

As shown in FIG. 13, the insulating layer 220 of the first busbar 200 may protrude from the cell string 100 along the second direction F2. Alternatively, as shown in FIG. 14, one end of the insulating layer 220 of the first busbar 200 along the second direction F2 is coplanar with one end of the cell string 100 along the second direction F2. In other words, one end of the cell string 100 along the second direction F2 has a first end surface 103, and one end of the insulating layer 220 along the second direction F2 has a second end surface 221. The first end surface 103 and the second end surface 221 are coplanar or lie on the same plane perpendicular to the second direction F2.

In this way, the insulating layer 220 of the first busbar 200 can achieve superior electrical isolation between the conductive body 210 of the first busbar 200 and the opposite-polarity grid lines of the plurality of solar cells 110 in the same cell string 100, as well as between the conductive body 210 and opposite-polarity welding ribbons electrically connected to the solar cells 110, thereby reducing the possibility of short circuit.

In the specific embodiment shown in FIG. 11, the photovoltaic module includes twelve cell strings 100 and a middle busbar 600. The twelve cell strings 100 are substantially symmetrically arranged with respect to the middle busbar 600. Six cell strings 100 on the same side of the middle busbar 600 are arranged along the third direction F3 and divided into three cell string groups. Each cell string group includes adjacent two cell strings 100 which are connected in parallel. The adjacent two cell strings 100 in each group are reversely connected in parallel to a diode 700 via the middle busbar 600 and the first busbar 200. In adjacent two cell string groups, one cell string 100 of one group is connected in series with one cell string 100 of the other group. Such series connection can be realized through the edge busbar 500, or alternatively through the middle busbar 600 and the first busbar 200.

As such, one cell string 100 from each of the three cell string groups on the same side of the middle busbar 600 are connected in series to form a large cell string, so as to increase the power generation capacity of the photovoltaic module.

In some embodiments, the photovoltaic module further includes a first cover plate 810, a second cover plate 820, a first adhesive film 830, and a second adhesive film 840. Along the first direction F1, the first adhesive film 830 is arranged on one side of the cell string 100, and the second adhesive film 840 is arranged on another side of the cell string 100. Along the first direction F1, the first cover plate 810 is arranged on the side of the first adhesive film 830 away from the cell string 100, and the second cover plate 820 is arranged on a side of the second adhesive film 840 away from the cell string 100.

A plurality of cell strings 100 may be arranged between the first adhesive film 830 and the second adhesive film 840.

The first adhesive film 830 and the second adhesive film 840 may be made of at least one of ethylene-vinyl acetate (EVA) adhesive film, polyolefin elastomer (POE) adhesive film, and polyvinyl butyral (PVB) adhesive film.

The first cover plate 810 and the second cover plate 820 can be light-transmitting cover plates, such as glass cover plates and plastic cover plates.

The photovoltaic module may further include a frame. The first cover plate 810, the first adhesive film 830, the cell string 100, the second adhesive film 840 and the second cover plate 820 are laminated to form a laminated assembly. The frame is arranged around a periphery of the laminated assembly. The frame can protect the edges of the laminated assembly, improve the overall mechanical strength of the photovoltaic module, and facilitate transportation and installation thereof.

In some embodiments, the photovoltaic module further includes a buffer layer 850 located between the solar cell 110 and the first adhesive film 830. The buffer layer 850 is disposed on one side of the first busbar 200, which can reduce the risk of hidden cracks of the solar cell 110 during lamination.

The buffer layer 850 may be made of at least one of ethylene-vinyl acetate (EVA) adhesive film, polyolefin elastomer (POE) adhesive film, and polyvinyl butyral (PVB) adhesive film.

In the embodiment shown in FIG. 1, the buffer layer 850 is located on at least one side of the first busbar 200 along the second direction F2.

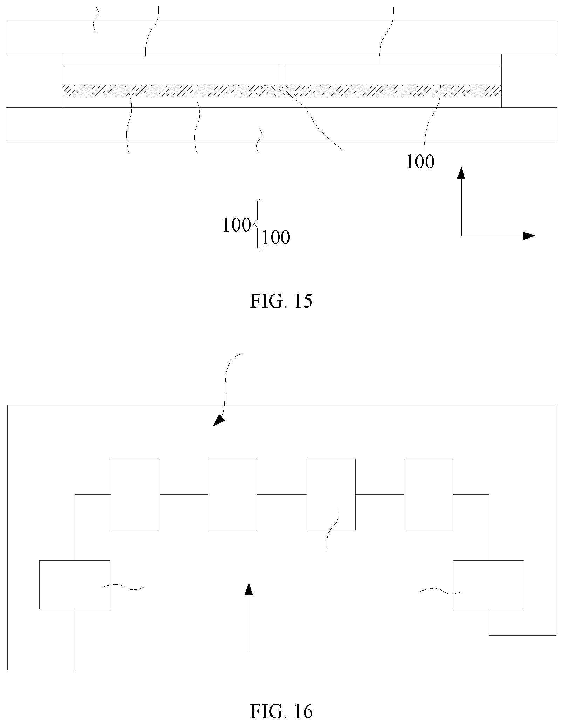

In the embodiment shown in FIG. 11, the buffer layer 850 is located on at least one side of the first busbar 200 along the third direction F3 (as shown in FIG. 15).

The present embodiment further provides a method of manufacturing a busbar, including the following steps:
In step S10, a conductive body is provided; the conductive body has a first outer surface and a second outer surface opposite to each other along the first direction.
In step S20, an insulating layer is formed at least on the first outer surface.

Specifically, step S20 of forming the insulating layer at least on the first outer surface may include step S21: an insulating layer is formed at least on the first outer surface by spraying.

Alternatively, step S20 of forming the insulating layer at least on the first outer surface may include step S22: an insulating material is placed at least on the first outer surface and the insulating material is heated to form the insulating layer at least on the first outer surface.

The present embodiment also provides a busbar manufacturing apparatus, which includes a feeding mechanism 1 and a curing mechanism 2. The feeding mechanism 1 is configured to supply insulating material at least to the first outer surface 211 of the conductive body 210, and the curing mechanism 2 is configured to cure the insulating material to form the insulating layer 220.

Optionally, the feeding mechanism 1 and the curing mechanism 2 are arranged sequentially along the extending direction of the conductive body 210, which is parallel to the second direction F2 or the third direction F3, and both the feeding mechanism 1 and the curing mechanism 2 are movable along the extending direction of the conductive body 210.

As such, the feeding mechanism 1 can be moved along the extending direction of the conductive body 210 to supply insulating material at least to the first outer surface 211 of the conductive body 210. Afterwards, the curing mechanism 2 moves along the extending direction of the conductive body 210 to cure the insulating material, so as to form the insulating layer 220.

In some embodiments, the feeding mechanism 1 is provided with a plurality of first feeding ports 11 facing the first outer surface 211, which are configured to feed insulating material to the first outer surface 211.

In other embodiments as shown in FIG. 16, the feeding mechanism 1 is provided with a plurality of first feeding ports 11 facing the first outer surface 211 for feeding insulating material to the first outer surface 211, and is further provided with a plurality of second feeding ports 12 facing the third outer surface 213 for feeding insulating material to the third outer surface 213.

Both the first feeding ports 11 and the second feeding ports 12 are spray nozzles, which are configured to spray insulating material onto the first outer surface 211 and the third outer surface 213, respectively.

In some embodiments, the curing mechanism 2 is provided with a plurality of first curing members 21 facing the first outer surface 211 to cure the insulating material on the first outer surface 211. The first curing members 21 may be ultraviolet lamps or other components capable of realizing curing of insulating materials.

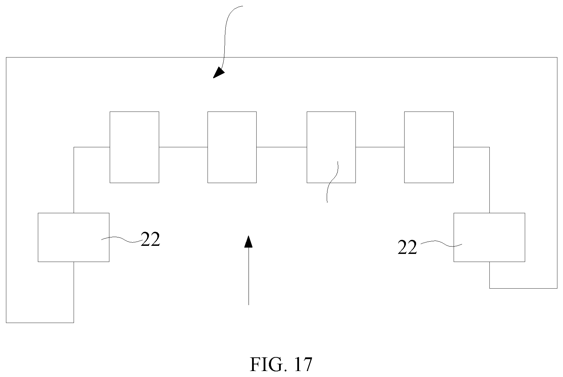

In other embodiments, as shown in FIG. 17, the curing mechanism 2 is provided with a plurality of first curing members 21 facing the first outer surface 211, and the plurality of first curing members 21 are configured to cure the insulating material on the first outer surface 211. The curing mechanism 2 is further provided with a plurality of second curing members 22 facing the third outer surface 213 for curing the insulating material disposed on the third outer surface 213.

The second curing members 22 may be ultraviolet lamps or other components capable of curing insulating materials.

## Claims

1. A photovoltaic module, comprising:
a cell string (100) comprising a solar cell (110) having a rear surface (112); and
a first busbar (200) located on the rear surface (112) of the solar cell (110) and comprising:
a conductive body (210) having a first outer surface (211) facing the rear surface (112) along a first direction (F1), and the conductive body (210) being electrically connected to the cell string (100); and
an insulating layer (220) disposed at least on the first outer surface (211), and the insulating layer (220) being made of insulating adhesive or ethylene-vinyl acetate copolymer.

2. The photovoltaic module according to claim 1, wherein the conductive body (210) further comprises a second outer surface (212) opposite to the first outer surface (211) along the first direction (F1) and a third outer surface (213) connected between the first outer surface (211) and the second outer surface (212), and the insulating layer (220) is disposed on the first outer surface (211) and the third outer surface (213).

3. The photovoltaic module according to claim 1, wherein the insulating layer (220) comprises a plurality of insulating sub-layers that are laminated, and adjacent two insulating sub-layers are made of different materials.

4. The photovoltaic module according to claim 1, wherein a thickness of the insulating layer (220) ranges from 150µm to 250µm.

5. The photovoltaic module according to claim 1, wherein a plurality of cell strings (100) are provided, each of the plurality of cell strings (100) comprises a plurality of solar cells (110) arranged along a second direction (F2) and connected in series sequentially;
wherein the photovoltaic module further comprises a first welding ribbon (300) electrically connected to the plurality of cell strings (100);
wherein in the plurality of cell strings (100), a solar cell (110) connected to the first welding ribbon (300) is defined as a first solar cell (110), and a solar cell (110) adjacent to the first solar cell (110) along the second direction (F2) is defined as a second solar cell (110);
wherein the first busbar (200) is disposed on a rear surface (112) of at least one of the first solar cell (110) and the second solar cell (110);
wherein the first welding ribbon (300) is located on the rear surface (112) of the first solar cell (110), the first welding ribbon (300) extends to a side of the conductive body (210) away from the adjacent solar cell (110) along the first direction (F1), and the first welding ribbon (300) is electrically connected to the conductive body (210).

6. The photovoltaic module according to claim 5, wherein the first busbar (200) is disposed on the rear surface (112) of the second solar cell (110).

7. The photovoltaic module according to claim 6, wherein the first solar cell (110) and the second solar cell (110) are located on an outer side of a same cell string (100) in the second direction (F2), and in the second direction (F2), the first solar cell (110) is located on an outer side of the second solar cell (110).

8. The photovoltaic module according to claim 6, wherein the plurality of cell strings (100) are arranged in the second direction (F2);
wherein the first solar cell (110) is located in one of adjacent two cell strings (100) in the second direction (F2), and the second solar cell (110) is located in another of the adjacent two cell strings (100) in the second direction (F2).

9. The photovoltaic module according to claim 5, wherein the plurality of cell strings (100) are arranged in a third direction (F3);
wherein the plurality of cell strings (100) arranged in the third direction (F3) are electrically connected to the conductive body (210) of a same first busbar (200).

10. The photovoltaic module according to claim 5, further comprising:
a plurality of second welding ribbons (400) spaced apart on the rear surface (112) of the solar cell (110) in the third direction (F3), wherein in each of the plurality of cell strings (100), adjacent two solar cells (110) are electrically connected via the plurality of second welding ribbons (400);
wherein the first busbar (200) is in contact with the second welding ribbons (400) via the insulating layer (220).

11. The photovoltaic module according to claim 1, wherein the cell string (100) comprises a plurality of solar cells (110) arranged along a second direction (F2);
wherein the photovoltaic module further comprises an edge busbar (500) disposed on one side of the cell string (100) in the second direction (F2) and electrically connected to the cell string (100);
wherein the conductive body (210) protrudes out of the cell string (100) along the second direction (F2) and is electrically connected to the edge busbar (500).

12. The photovoltaic module according to claim 11, wherein the insulating layer (220) protrudes out of the cell string (100) along the second direction (F2); or
one end of the insulating layer (220) in the second direction (F2) is coplanar with one end of the cell string (100) in the second direction (F2).

13. The photovoltaic module according to claim 11, wherein the conductive body (210) comprises a first portion (214) protruding from the insulating layer (220) along the second direction (F2), and a dimension of the first portion (214) in the second direction (F2) ranges from 0.3 cm to 0.8 cm.

14. The photovoltaic module according to claim 5, wherein the conductive body (210) has a second outer surface (212) opposite to the first outer surface (211) along the first direction (F1), and a third outer surface (213) connected between the first outer surface (211) and the second outer surface (212);
wherein the third outer surface (213) is provided with a welding groove (215), a side wall of the welding groove (215) adjacent to the second outer surface (212) is provided with a welding opening (216) in communication with the welding groove (215), and an end of the first welding ribbon (300) connected to the conductive body (210) is located inside the welding groove (215).

15. The photovoltaic module according to claim 1, further comprising a first cover plate (810), a second cover plate (820), a first adhesive film (830), and a second adhesive film (840);
wherein along the first direction (F1), the first adhesive film (830) is arranged on one side of the cell string (100), the second adhesive film (840) is arranged on another side of the cell string (100);
wherein along the first direction (F1), the first cover plate (810) is arranged on the side of the first adhesive film (830) away from the cell string (100), and the second cover plate (820) is arranged on a side of the second adhesive film (840) away from the cell string (100).
